(19) Europäisches Patentamt
European Patent Office
Office européen des brevets

(11) **EP 1 672 101 B1**

(12) **EUROPÄISCHE PATENTSCHRIFT**

(45) Veröffentlichungstag und Bekanntmachung des Hinweises auf die Patenterteilung:
**11.05.2011  Patentblatt 2011/19**

(51) Int Cl.:
*C25F 3/08* (2006.01)    *H01L 21/321* (2006.01)
*B24B 37/04* (2006.01)    *C25F 3/26* (2006.01)
*B23H 5/06* (2006.01)

(21) Anmeldenummer: **05026427.4**

(22) Anmeldetag: **03.12.2005**

(54) **Verfahren zur elektrochemischen Abtragung von Refraktärmetallen oder -legierungen und Verwendung einer Lösung zur Durchführung dieses Verfahrens**

Process for the electrochemical removal of refractory metals or their alloys and use of a solution for this process

Procédé d'enlèvement de metaux refractaires ou de leur alliages et utilisation de solutions pour un tel procédé

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **16.12.2004   DE 102004060507**

(43) Veröffentlichungstag der Anmeldung:
**21.06.2006   Patentblatt 2006/25**

(73) Patentinhaber: **Karlsruher Institut für Technologie 76131 Karlsruhe (DE)**

(72) Erfinder:
• **Holstein, Nils, Dr.**
  **76137 Karlsruhe (DE)**
• **Konys, Jürgen, Dr.**
  **76344 Eggenstein-Leopoldshafen (DE)**
• **Krauss, Wolfgang, Dr.**
  **74613 Öhringen (DE)**

(56) Entgegenhaltungen:
WO-A-2005/075711    US-A- 4 111 767
US-A1- 2003 116 446    US-A1- 2004 053 499
US-A1- 2005 003 637

Bemerkungen:
Die Akte enthält technische Angaben, die nach dem Eingang der Anmeldung eingereicht wurden und die nicht in dieser Patentschrift enthalten sind.

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur elektrochemischen Abtragung von Refraktärmetallen oder -legierungen nach dem Oberbegriff des Anspruchs 1 und die Verwendung einer Lösung zur Durchführung dieses Verfahrens.

Als *Refraktärmetalle* werden im Zusammenhang mit dieser Erfindung Wolfram, Molybdän und Tantal bezeichnet. Unter *Refraktärlegierungen* werden Legierungen aus einem der genannten Refraktärmetalle mit einem oder mehreren Übergangsmetallen der III. bis VII. Nebengruppe des Periodensystems verstanden. Das erfindungsgemäße Verfahren eignet sich jedoch auch für Refraktärmetalle oder -legierungen, die fein verteilte Partikel aus Oxiden, Nitriden oder Carbiden der Übergangsmetalle der III. bis VI. Nebengruppe des Periodensystems oder ein Seltenerdelement wie Cer umfassen.

Unter *Abtragung* wird die Fertigung oder oberflächennahe Strukturierung von dreidimensional geformten Körpern (Werkstücken) aus einem Refraktärmetall oder einer -legierung, die z. B. als Rohling in Form von Stäben oder Platten vorliegen, verstanden. Die mit diesem Verfahren mittels Abtrag hergestellten Strukturen weisen Abmessungen von 0,1 bis 10 mm und Aspektverhältnisse (z.B. Grabenbreite zu Grabentiefe) bis 1:10 auf. Das Verfahren ist ebenso zur Herstellung von gekrümmten Oberflächen mit Krümmungsradien von 0,1 bis 10 mm oder zur Einbringung von Bohrungen mit Durchmessern von 0,1 bis 10 mm in das Werkstück (Rohling) geeignet.

Eine Strukturierung durch mechanische Umformung wie z.B. durch Stanzen, Prägen oder Pressen scheidet für Refraktärmetalle oder -legierungen infolge ihrer hohen Härte oder Zähigkeit und der hierfür erforderlichen Umformtemperaturen, die höher als die zulässigen Werkzeugtemperaturen sind, aus. Eine spanende Bearbeitung durch z. B. Bohren, Drehen oder Fräsen ist aus Geometriegründen, Werkzeugverschleiß oder Kostengründen nicht möglich.

Die Bearbeitung von Refraktärmetallen oder -legierungen mit Elektromechanischer Funkenerosion *(Electro-Discharge Machining EDM)* wäre von der Geometrie her zwar möglich, scheidet aber infolge von Defekten, die die zur Abtragung erforderlichen hochenergetischen Strompulse oder -überschläge in die Werkstücke einbringen, auf Grund von Werkzeugverschleiß sowie einer erheblichen Bearbeitungsdauer aus. Lasererosionstechniken sind aufgrund von Gefügeveränderungen wie Rekristallisation in den Refraktärmetallen oder -legierungen mit einhergehendem Festigkeitsverlust oder Mikrorissbildung nicht anwendbar.

In W. König, F. Klocke, Fertigungsverfahren 3, Elektrochemisches Abtragen, Springer, 1997, Seite 91-121 wird das als *ECM (Electro-Chemical Machining)* bekannte Verfahren beschrieben, das vor allem im Werkzeugbau angewandt wird. Dieses auch großtechnisch einsetzbare Verfahren zur Formgebung erlaubt eine Strukturierung eines metallischen Werkstücks durch stromunterstütztes lokales Auflösen eines Metalls, indem das Werkstück elektrochemisch in einem Elektrolyten (Salzlösung oder reaktive Substanz) als Anode geschaltet wird. Bei Stromfluss werden anodische Materialien oxidiert und aufgelöst. Die Gegenelektrode wirkt dabei als kathodisch polarisiertes Werkzeug und kann bei entsprechender Positionierung als Formnegativ in das Anodenmaterial abgeformt werden. Das Abtragsvolumen ergibt sich durch Höhe und Wirkzeit des Arbeitsstromes sowie durch Spülung mit Elektrolyt und entsprechender Werkzeugausführung. Mit ECM lassen sich vor allem Stähle einfach bearbeiten. Der Elektrolyt wird hierbei auf einen neutralen pH-Wert eingestellt und das abgetragene Material fällt meist in Form von Oxiden (Eisenoxide) aus der Elektrolytlösung aus.

Insbesondere auf Grund von Passivierungseffekten und geringen Elektrodenstandzeiten wird ECM bisher weder für Refraktärmetalle noch für -legierungen eingesetzt. Daher gilt die Erzeugung von Oberflächenstrukturen in Refraktärmetallen oder -legierungen bislang als nicht möglich.

Aus einer Produktinformation des Refraktärmetall-Herstellers Fa. Plansee zu Wolfram, Reutte, Austria 2003, geht hervor, dass sich Ätzprozesse ohne Stromunterstützung für Refraktärmetalle z.B. zum Beizen (Reinigen) von Oberflächen eignen.

Nach E. Lassner und W.D. Schubert, Tungsten, Part Electrolytes, Seite 127, Kluwer Academic, NY, 1998, werden stromunterstützte Ätzprozesse zum Elektropolieren (Glätten oder Reinigen) von Oberflächen angewandt.

Refraktärmetalle lassen sich (elektr)chemisch durch ein- oder mehrkomponentige Systeme ätzen. Hierfür werden meist Lösungen aus Alkalimetallhydroxiden MeOH (KOH, NaOH, LiOH) eingesetzt, die sich aber nur für starke und kurze Ätzungen eignen. Mit stärker konzentrierten Lösungen (mehr als 1-2 Mol/l) erfolgt die Ätzung auch ohne Stromfluss, weshalb alle wässrigen, chemischen Ätzmittel auf derartigen Lösungen basieren.

Lösungen aus MeOH besitzen einen Dissoziationsgrad von 100%, d.h. bei 1-molaren Lösungen liegen 1 mol/l $OH^-$-Ionen vor, was einen pH-Wert um 14 bewirkt. Die so hervorgerufene Ätzung der Refraktärmetalle ohne Stromeinfluss bewirkt, dass sich die Ätzrate nicht mehr über den angelegten Strom regeln lässt.

Aufgrund ihrer hohen Ionenstärke werden Lösungen aus MeOH ohne Zusatz an Leitsalzen eingesetzt. Dadurch führt bereits ein geringer Verbrauch an vorhandenen $OH^-$-Ionen zu einer Änderung der Konzentration des Ätzmittels und zugleich der elektrischen Leitfähigkeit. Ein solches System ist daher auch bei von außen aufgeprägtem Stromfluss nicht über längere Zeit-prozessstabil.

Ein weiter Nachteil von Lösungen aus MeOH beruht auf ihrer Verwendung als Entwickler und Stripper für die Entfernung von Lacken, die vor allem in der Lithographie zur Maskierung eingesetzt werden. Substrate, die mit solchen Masken versehen wurden, lassen sich daher nicht mit derartigen Lösungen ätzen, da sich die Masken sofort auflösen würden.

Die US 2003/116446 A1 und die US 2004/053499 A1 offenbaren Verfahren und Elektrolyte zum elektrochemischen Entfernen von Wolfram und Tantal, insbesondere durch ECM.

Gemäß der US 2003/116446 A1 basiert der Elektrolyt auf einem Phospatsystem als Leitsalz, wobei mittels KOH ein pH-Wert von 3-10 eingestellt wird. Als Chelatbildner werden Amine wie z.B. Ammoniak zugesetzt.

Gemäß der US 2004/053499 A1 basiert der Elektrolyt auf Salpetersäure, wobei ein pH-Wert von 2-10 eingestellt wird. Bei einem pH-Wert von 10 liegt damit zwangsläufig ein Nitrat vor. Auch hier werden Amine als Chelatbildner bzw. Puffer zugesetzt.

Ausgehend hiervon ist es die Aufgabe der vorliegenden Erfindung, ein Verfahren zur Abtragung von Refraktärmetallen oder -legierungen sowie die Verwendung eines Elektrolyten zur Durchführung dieses Verfahrens vorzuschlagen, die die genannten Nachteile und Einschränkungen nicht aufweisen.

Diese Aufgabe wird im Hinblick auf das Verfahren durch die Schritte des Anspruchs 1 und im Hinblick auf die Verwendung durch die Merkmale des Anspruchs 9 gelöst. Die Unteransprüche beschreiben jeweils vorteilhafte Ausgestaltungen der Erfindung.

Zur elektrochemischen Formgebung mittels Abtragung wird das zu bearbeitende Werkstück aus einem Refraktärmetall oder einer -legierung in einer Elektrolytlösung elektrochemisch als Anode geschaltet. Grundsätzlich werden bei Stromfluss die in der Oberfläche dieses Werkstücks befindlichen Metallatome oxidiert und gehen als Ionen in Lösung. Bei Wolfram und anderen Refraktärmetallen oder -legierungen funktioniert dieser Prozesse je nach Zusammensetzung des Elektrolyts bisher nur eingeschränkt, da diese Werkstoffe nach der Oxidation zu unlöslichen Oxiden reagieren, die als passivierende Schicht mit Schichtdicken um 10 $\mu$m (Wolfram) auf der Oberfläche haften bleiben und so den weiteren Stromfluss weitgehend unterbinden.

Das erfindungsgemäße Verfahren basiert auf dem Einsatz von erfindungsgemäßen Lösungen, die als Elektrolyt gleichzeitig für eine vollständige Entfernung der Passivschicht sorgen, so dass selbst bei niedrigen angelegten Spannungen Stromdichten oberhalb von 100 mA/cm$^2$ erreicht werden können.

Erfindungsgemäß wird als Elektrolyt eine Lösung eingesetzt, die mindestens zwei Komponenten umfasst:

Die erste Komponente umfasst ein Leitsalz und stellt somit die elektrische Leitfähigkeit des Elektrolyten sicher. Erfindungsgemäß wird hierfür ein Metallnitrat $MeNO_3$ eingesetzt, wobei das Metall Me Natrium Na, Kalium K oder Lithium Li ist. Bei der elektrochemischen-Abtragung von Wolfram eignet sich hierfür besonders bevorzugt eine Konzentrationen im Bereich von 1-1,5 mol/l, insbesondere von 1,25 mol/l.

Entscheidend ist, dass sich das Leitsalz vollkommen inert in Bezug auf die Abtragung des Refraktärmetalls oder der -legierung verhält, es aber durch seine hohe Löslichkeit und dem hohen Dissoziationsgrad von ungefähr 1 (d.h. praktisch 100% Ionisierung gemäß z.B. $NaNO_3 \rightarrow Na^+ + NO_3^-$) für eine beständig hohe Ionenkonzentration sorgt und somit die zwingend erforderliche elektrische Leitfähigkeit der Elektrolytlösung bewirkt.

Die zweite Komponente umfasst eine Base, die die chemischen Vorgänge während des Prozesses steuert. Hierfür eignet sich insbesondere ein leicht löslicher, gering dissoziierender Elektrolyt einer mittleren Base mit einem Dissoziationsgrad im bereich von 0,1 % bis 5 %, bevorzugt 1 %, besonders bevorzugt eine Lösung, die ein Amin, insbesondere Ammoniak $NH_3$ umfasst, mit einer Konzentration von mindestens 1 mol/l. Auf diese Weise wird ein mäßig starker alkalischer Elektrolyt mit einem pH-Wert zwischen 10 und 12,5, bevorzugt zwischen 11 und 12 erhalten.

Diese Zusammensetzung löst zunächst die bei anodischer Polarisation unter Stromfluss z.B. für Wolfram gemäß $W + 3 H_2O \rightarrow WO_3 + 6 H^+ + 6e^-$ gebildete Oxidschicht auf: z.B. über den Weg $WO_3 + 2 NH_3 + H_2O \rightarrow WO_4^{2-} + 2 NH_4^+$. Hieran anschließend wird das freie Metall z.B. gemäß der Gesamtreaktion $W + 4 H_2O + 8 NH_3 + H_2O \rightarrow WO_4^{2-} + 8 NH_4^+ + 6 e^-$ für eine weitere Auflösung freigelegt. Die Wirkung der Base (z.B. Ammoniak) wird durch die hohe elektrische Leitfähigkeit des als erste Komponente zugesetzten Leitsalzes erheblich gesteigert. Mit z.B. Ammoniak als Base in Abwesenheit des Leitsalzes konnten nur geringe Stromdichten bis ca. 10 mA/cm$^2$ erreicht werden, womit eine effektive Strukturierung nicht möglich wäre.

Die besonders bevorzugte Base Ammoniak ist ein nur mäßig starker Elektrolyt, dissoziiert also nicht wie KOH oder NaOH vollständig. Auch wenn große Konzentrationen an Ammoniak in Wasser gelöst werden (max. 25 Gew.%), beträgt die Konzentration $c_{NH4+}$ an freien dissoziierten Ammoniumionen aufgrund der sehr geringen Dissoziationskontante $k_{NH_3}$; nur Bruchteile der Ammoniakkonzentration $c_{NH_3}$ : $NH_3 + H_2O \rightarrow NH_4^+ + OH^-$, wobei $k_{NH_3} = 10^{-4,75}$.

Die jeweilige Konzentration an dissoziiertem Ammoniumhydroxid $c_{OH^-}$ lässt sich gemäß der Gleichung 1

$$k_{NH_3} = \frac{c_{NH_4^+} \times c_{OH^-}}{c_{NH_3}} \quad \Leftrightarrow \quad c_{OH^-} = \sqrt{c_{NH_4^+} \times c_{OH^-}} = \sqrt{k_{NH_3} \times c_{NH_3}} \qquad (1)$$

ermitteln. So sind in einer 1-molaren Ammoniaklösung ($c_{NH_3} = 10^° $ mol/l) nur $c_{OH^-} = 10^{-2,375}$ mol/l OH$^-$-Ionen vorhanden, was $10^{-11,675}$ $H^+$-Ionen entspricht, woraus sich ein pH = 11,7 ergibt.

Auf diese Weise erklärt sich ein pH-Wert deutlich unterhalb von 14 trotz 1-molarer Konzentration.

Trotz wesentlich geringerer $OH^-$-Konzentration (= 0,1 % gegenüber KOH) ergeben sich Vorteile gegenüber Alkalimetallhydroxiden: Werden die $OH^-$-Ionen aus der wässrigen Ammoniaklösung infolge der Reaktion mit $WO_3$ verbraucht, so stellt sich gemäß dem Massenwirkungsgesetz die ursprüngliche Konzentration entsprechend Gleichung 1 schnell wieder her, und zwar solange, bis das gesamte Ammoniak verbraucht ist. Hierdurch ergibt sich über längere Zeit eine sehr konstante Ätzmittelkonzentration, wodurch sich eine ständige Nachregulierung des pH-Wertes bzw. der Ätzmittelkonzentration erübrigt. Zudem sorgt eine kinetisch kontrollierte Ätzmittelkonzentration für eine genauere Abformung von dreidimensionalen Strukturen mit hohen Aspektverhältnissen. Da ausreichend hohe Stromdichten erreicht wurden, konnten bisher Ätzraten bis auf $10^2$ $\mu$m/h erzielt werden.

Das erfindungsgemäße Verfahren eignet sich insbesondere auch zur mikrotechnischen Strukturierung von Werkstücken aus einem Refraktärmetall oder einer -legierung. Hierfür sind zwei Verfahren möglich:

a) Maskierung der zu bearbeitenden Oberfläche des Werkstücks mit einer Maske, vorzugsweise aus einem Resist oder einer E-delmetallbeschichtung, die in den beschriebenen alkalischen Lösungen beständig ist. Durch Einstellung der Spannung und des Stroms im System Werkstück (= Anode), Elektrolyt (= Lösung) und Werkzeug (= Kathode) wird dem Werkstück eine vorgegebene Oberflächengeometrie mit nur gering von der Senkrechten abweichenden Flanken aufgeprägt.

b) Die Formgebung des Werkstückes kann auch dadurch erreicht werden, dass das Werkzeug, das sich in der eingesetzten Lösung inert verhält, maskiert oder strukturiert wird und auf diese

Weise die Werkzeugform durch den elektrisch unterstützten Abtragungsprozess auf das Werkstück kopiert wird. Die Maskierung der nicht aktiven Flächen beim Abtragungsprozess kann bei Werkzeugen, die aus einer Stahl-Basislegierung gefertigt sind, durch Aufbringen einer elektrisch isolierenden Schicht gelöst werden.

Bei der Verwendung von Werkzeugen, die aus einem Metall der IV. Nebengruppe des Periodensystems oder einer ein derartiges Metall enthaltenden Legierung gefertigt, erfolgt die elektrische Isolation durch Aufwachsen von Oxidschichten in Argondampf-Gemischen. Dieses Verfahren erlaubt längere Standzeiten der Werkzeuge und eine verbesserte Flankenausbildung.

Die für die Abtragung (Strukturierungsprozess) eingesetzte Stromquelle liefert einen Gleichstrom (konstante Polarisierung von Kathode zu Anode - anodischer Strom), dieser kann jedoch zeitlich konstant oder pulsierend sein. Eine Wechselspannung (anodische und kathodische Strompulse) kann insbesondere zur Auflösung von Oberflächenschichten dem Abtragungs-Gleichstrom überlagert werden, wobei der Anodenstrom jedoch deutlich überwiegen muss (ca. 99%). Negative Strompulse dürfen nur geringste Schichten abtragen. Gleichströme mit kurzer Pulsdauer erhöhen die Konturschärfe.

Die Oberfläche des Werkstücks muss mit frischer Elektrolytlösung gespült werden. Der Abstand zwischen Werkzeug und Werkstück kann zum besseren Austausch der Elektrolytlösungen im Arbeitsbereich synchronisiert zu den Gleichstrompulsen verändert werden.

Das erfindungsgemäße Verfahren besitzt die folgenden Vorteile:

- Reproduzierbarkeit vorgegebener Geometrien.
- Preisgünstige Fertigung durch einfache Prozessführung.
- Steuerbarkeit der Ätzrate über angelegten Strom, Abstand von Werkstück zum Werkzeug einschl. dessen zeitlicher Veränderung, Strompulsformen einschl. deren zeitliche Veränderung, Synchronisation zum Abstand, sowie über Auswahl des Elektrolyten.
- Herstellung mikrostrukturierter Bauteile aus einem Refraktärmetall ohne Gefügeveränderung, Mikrorisse oder -kerben.

Mit dem erfindungsgemäßen Verfahren lassen sich dreidimensional geformte mikrotechnisch strukturierte Körper aus Refraktärmetallen oder -legierungen, die sich als aktive Komponente in einem Hochtemperatur-Hochdruck-Gaswärmetauscher einsetzen lassen. Gleichzeitig erlaubt dieses Verfahren die Bearbeitung von makroskopischen, gekrümmten Oberflächen mit definierten Krümmungsradien im Millimeterbereich. Ebenso können damit Sacklöcher (Bohrungen) aus dem Rohling herausgearbeitet werden. Der Oberflächenstruktur erfüllt dabei hohe Anforderungen im Hinblick auf Gratfreiheit, Kratzerfreiheit und Ausbruchsfreiheit.

Das erfindungsgemäße Verfahren dient zur stromunterstützten gezielten Auflösung von Werkstücken aus Refraktärmetallen oder -legierungen, d.h. zur Konturfertigung nach vorgegebener technischer Zeichnung unter Einsatz von mikrostrukturierten Werkzeugen auch mit elektrisch isolierten Flanken (nicht Arbeitsflächen) durch Beschichtung z.B. mit Lack oder aufgewachsenen, elektrisch isolierenden und chemisch resistenten Oxidschichten oder Werkstückoberflächen, die durch geeignete Maskierungsprozesse zum Zwecke der Mikrostrukturierung von Werkstücken aus Refraktärmetallen oder -legierungen verändert wurden.

Mit dem erfindungsgemäßen Verfahren strukturierte Werkstücke aus Refraktärmetallen oder -legierungen lassen sich z.B. als heliumgekühlter Wärmetauscher für einen Divertor in einem Fusionsreaktor oder zur effektiven Wärmeabfuhr und Kühlung von elektronischen Bauteilen verwenden. Mit diesem Verfahren hergestellte mikrostrukturierte Bauteilen aus Refraktärmetallen oder -legierungen, insbesondere aus Wolfram oder W-ODS (*Oxide Dispersion Strengthed Wolfram)* sind als Teile für den Bau eines Gaswärmetauschers mit einer Wärmeleitfähigkeiten von ca. 100 W/mK vorgesehen. Wolfram weist gegenüber Aluminium oder Kupfer eine höhere Beständigkeit insbesondere gegenüber Temperaturbelastungen auf.

Darüber hinaus können mit dem erfindungsgemäßen Verfahren strukturierte Werkstücke als verschleißfeste Werkzeuge, als Wärmetauscher mit hoher Leistung oder als Einspritzdüsen auf Hartmetallbasis verwendet werden.

Die Erfindung wird im Folgenden anhand von Ausführungsbeispielen erläutert.

In einer elektrochemischen Apparatur wurden mehrere Proben aus W, W-ODS, Mo und Ta mit Standardlösungen mittels anodischer Polarisierung sowohl potentiostatisch als auch galvanostatisch bis in Tiefen bis zu 1,0 mm strukturiert. Als Standardlösungen wurden getestet:

10 Gew.% NaNO3; = 1,25 Mol, pH = 7 (Grundlösung)

- salpetersaure Lösungen, pH = 5, 3, 1
- alkalische Lösungen, pH = 9, 11, 14 ammoniakalische 10 Gew.% NaN03-Lösung, pH = 9, 10, 11, 12 1 Mol NH3-Lösung; pH = 12

Im Fall von Wolfram erwies sich eine Lösung aus 1 Mol/l Ammoniak $NH_3$ und 1,0 - 1,5 Mol/l Natriumnitrat $NaNO_3$, bevorzugt 1,25 Mol/l $NaNO_3$ mit einem pH = 12 als ein Elektrolytsystem, das zu guten Ergebnissen führte.

Die Strukturierung der Werkstücke erfolgte unter Maskierung mittels UV-Lithographie. Hierbei wird das Substrat mit einer UV-sensitiven Schicht versehen und mit UV-Licht durch eine Schwarz-Weiß-Maske belichtet. Die belichteten Bereiche lösen sich in stark verdünnter Natronlauge auf, während die abgeschatteten Bereiche erhalten bleiben.

Die maskierte Probe wird als Arbeitselektrode mit einer konstanten anodischen Stromdichte oder einem konstanten Potential polarisiert, wobei technisch eine konstante Stromdichte bevorzugt wird. Die Strukturierung erfolgt über 8 Stunden bei einer Stromdichte von 100 mA/cm$^2$.

**Patentansprüche**

1. Verfahren zur elektrochemischen Abtragung von Wolfram, Molybdän oder Tantal oder einer Legierung aus einem der genannten Metalle mit einem oder mehreren Übergangsmetallen der III. bis VII. Nebengruppe des Periodensystems, bei dem ein Werkstück aus Wolfram, Molybdän, Tantal oder der Legierung als Anode und ein leitfähiges Werkzeug zur Abtragung als Kathode geschaltet werden, wobei sich zwischen dem Werkstück und dem Werkzeug ein Elektrolyt befindet, und zwischen Anode und Kathode eine elektrische Spannung angelegt wird, wodurch ein Strom durch das Werkstück, den Elektrolyten und das Werkzeug fließt, der Teile des Werkstücks abträgt, wobei als Elektrolyt eine Lösung eingesetzt wird, die ein Metallnitrat $MeNO_3$, wobei Me = Na, K oder Li ist, als Leitsalz und eine Base umfasst,
   **dadurch gekennzeichnet, dass** die Lösung einen pH-Wert zwischen 10 und 12,5 aufweist.

2. Verfahren nach Anspruch 1, **dadurch gekennzeichnet, dass** für die Lösung ein pH-Wert zwischen 11 und 12 gewählt wird.

3. Verfahren nach Anspruch 1 oder 2, **dadurch gekennzeichnet, dass** eine Base mit einem Dissoziationsgrad zwischen 0,1 % und 5 % eingesetzt wird.

4. Verfahren nach Anspruch 3, **dadurch gekennzeichnet, dass** als Base ein Amin eingesetzt wird.

5. Verfahren nach Anspruch 4, **dadurch gekennzeichnet, dass** als Base eine ammoniakhaltige Lösung eingesetzt wird.

6. Verfahren nach einem der Ansprüche 1 bis 5, **dadurch gekennzeichnet, dass** ein Werkstück aus Wolfram in eine Lösung aus Ammoniak und Natriumnitrat $NaNO_3$ eingebracht wird, die ein molares Verhältnis von 1:1 bis 1:1,5 aufweist.

**7.** Verfahren nach einem der Ansprüche 1 bis 6, **dadurch gekennzeichnet, dass** Bereiche auf der Oberfläche des Werkstücks mit einer Maskierung versehen werden, die inert gegenüber der Lösung ist.

**8.** Verfahren nach Anspruch 7, **dadurch gekennzeichnet, dass** als Maskierung ein passives Metall oder ein Resist gewählt wird.

**9.** Verwendung einer Lösung, die ein Metallnitrat $MeNO_3$, wobei Me = Na, K oder Li ist, als Leitsalz und eine Base umfasst und einen pH-Wert zwischen 10 und 12,5 aufweist, als Elektrolyt in einem Verfahren zur elektrochemischen Abtragung von Wolfram, Molybdän oder Tantal oder einer Legierung aus einem der genannten Metalle mit einem oder mehreren Übergangsmetallen der III. bis VII. Nebengruppe des Periodensystems, bei dem ein Werkstück aus Wolfram, Molybdän, Tantal oder der Legierung als Anode und ein leitfähiges Werkzeug zur Abtragung als Kathode geschaltet werden, wobei sich der Elektrolyt zwischen dem Werkstück und dem Werkzeug befindet, und zwischen Anode und Kathode eine elektrische Spannung angelegt wird, wodurch ein Strom durch das Werkstück, den Elektrolyten und das Werkzeug fließt, der Teile des Werkstücks abträgt.

**10.** Verwendung einer Lösung nach Anspruch 9 mit einem pH-Wert zwischen 11 und 12.

**11.** Verwendung einer Lösung nach Anspruch 9 oder 10, umfassend eine Base mit einem Dissoziationsgrad zwischen 0,1 % und 5 %.

**12.** Verwendung einer Lösung nach Anspruch 11, umfassend ein Amin als Base.

**13.** Verwendung einer Lösung nach Anspruch 12 mit Ammoniak.

**14.** Verwendung einer Lösung nach einem der Ansprüche 9 bis 13, umfassend Ammoniak und Natriumnitrat $NaNO_3$ in einem molaren Verhältnis 1:1 bis 1:1,5.

## Claims

**1.** Method for the electrochemical erosion of tungsten, molybdenum or tantalum or of an alloy of one of the said metals with one or a plurality of transition metals in Group III to VII of the periodic table, in which a workpiece of tungsten, molybdenum, tantalum or of the alloy is connected as the anode and a conductive tool for erosion is connected as the cathode, in which an electrolyte is present between the workpiece and the tool and an electrical voltage is applied between anode and cathode causing a current to flow through the workpiece, the electrolyte and the tool, eroding parts of the workpiece, and in which a solution containing a metal nitrate $MeNO_3$, - Me being Na, K or Li - as conducting salt and a base is used as the electrolyte,
**characterised in that** the solution has a pH value between 10 and 12.5.

**2.** Method according to Claim 1, **characterised in that** a pH value between 11 and 12 is selected for the solution.

**3.** Method according to Claim 1 or 2, **characterised in that** a base with a degree of dissociation between 0.1% and 5 % is used.

**4.** Method according to Claim 3, **characterised in that** an amine is used as the base.

**5.** Method according to Claim 4, **characterised in that** an ammonia-bearing solution is used as the base.

**6.** Method according to any of Claims 1 to 5, **characterised in that** a workpiece of tungsten is introduced into a solution of ammonia and sodium nitrate $NaNO_3$ which has a molar ratio of 1:1 to 1:1.5.

**7.** Method according to any of Claims 1 to 6, **characterised in that** regions on the surface of the workpiece are provided with masking that is inert to the solution.

**8.** Method according to Claim 7, **characterised in that** a passive metal or a resist is selected as masking.

**9.** Use of a solution which contains a metal nitrate $MeNO_3$, - Me being Na, K or Li - as conducting salt and a base and having a pH value between 10 and 12.5, as electrolyte in a method for the electrochemical erosion of tungsten, molybdenum or tantalum or of an alloy of one of the said metals with one or a plurality of transition metals in Group III to VII of the periodic table, in which a workpiece of tungsten, molybdenum, tantalum or of the alloy is connected as the anode and a conductive tool for erosion is connected as the cathode, in which the electrolyte is present between the workpiece and the tool, and an electrical voltage is applied between anode and cathode causing a current to flow through the workpiece, the electrolyte and the tool, eroding parts of the workpiece.

10. Use of a solution according to Claim 9 with a pH value between 11 and 12.

11. Use of a solution according to Claim 9 or 10, comprising a base with a degree of dissociation between 0.1% and 5 %.

12. Use of a solution according to Claim 11, comprising an amine as the base.

13. Use of a solution according to Claim 12 with ammonia.

14. Use of a solution according to any of Claims 9 to 13, comprising ammonia and sodium nitrate $NaNO_3$ in a molar ratio of 1:1 to 1:1.5.

**Revendications**

1. Procédé d'enlèvement électrochimique de tungstène, de molybdène ou de tantale ou d'un alliage de ces métaux avec un ou plusieurs métaux de transition des sous groupes III-VII de la classification périodique des éléments selon lequel on branche une pièce en tungstène, molybdène, tantale ou de l'alliage de ceux-ci comme anode et un outil conducteur pour l'enlèvement comme cathode,
un électrolyte se trouvant entre la pièce et l'outil, et
on applique une tension électrique entre l'anode et la cathode pour qu'un courant passe à travers la pièce, l'électrolyte et l'outil qui enlève des parties de la pièce, l'électrolyte étant une solution renfermant un nitrate métallique $MeNO_3$ dans lequel Me = Na, K ou Li constituant un sel conducteur et une base,
procédé **caractérisé en ce que**
la solution a un pH compris entre 10 et 12,5.

2. Procédé selon la revendication 1,
**caractérisé en ce qu'**
on fixe un pH compris entre 11 et 12 pour la solution.

3. Procédé selon la revendication 1 ou 2,
**caractérisé en ce qu'**
on utilise une base avec un degré de dissociation compris entre 0,1 % et 5 %.

4. Procédé selon la revendication 3,
**caractérisé en ce que**
comme base, on utilise une amine.

5. Procédé selon la revendication 4,
**caractérisé en ce que**
comme base, on utilise une solution ammoniacale.

6. Procédé selon l'une des revendications 1 à 5,
**caractérisé en ce qu'**
on place la pièce en tungstène dans une solution d'ammoniac et de nitrate de sodium $NaNO_3$ qui a un rapport molaire de 1:1 jusqu'à 1:1,5.

7. Procédé selon l'une des revendications 1 à 6,
**caractérisé en ce qu'**
on applique un masque sur des zones de la surface de la pièce, ce masque étant inerte par rapport à la solution.

8. Procédé selon la revendication 7,
**caractérisé en ce que**

comme masse, on utilise un métal passivé ou une laque photosensible.

9. Utilisation d'une solution renfermant un nitrate métallique $MeNO_3$ avec Me = Na, K ou Li, comme sel conducteur et une base et ayant un pH compris entre 10 et 12,5 comme électrolyte dans un procédé d'enlèvement électrochimique de tungstène, molybdène ou tantale ou d'un alliage de ces métaux avec un ou plusieurs métaux de transition des sous-groupes III-VII de la classification périodique des éléments, selon lequel on branche une pièce en tungstène, molybdène, tantale ou en un alliage de ceux-ci comme anode et un outil conducteur pour l'enlèvement, comme cathode,
l'électrolyte se trouvant entre la pièce et l'outil et on applique une tension électrique entre l'anode et la cathode pour faire passer un courant dans la pièce, l'électrolyte et l'outil pour enlever des parties de la pièce.

10. Utilisation d'une solution selon la revendication 9, ayant un pH compris entre 11 et 12.

11. Utilisation d'une solution selon la revendication 9 ou 10, renfermant une base avec un degré de dissociation compris entre 0,1 % et 5 %.

12. Utilisation d'une solution selon la revendication 11, renfermant comme base une amine.

13. Utilisation d'une solution selon la revendication 12, renfermant de l'ammoniac.

14. Utilisation d'une solution selon l'une des revendications 9 à 13, comportant de l'ammoniac et du nitrate de sodium $NaNO_3$ selon un rapport molaire de 1:1 jusqu'à 1:1,5.

**IN DER BESCHREIBUNG AUFGEFÜHRTE DOKUMENTE**

**In der Beschreibung aufgeführte Patentdokumente**

- US 2003116446 A1

- US 2004053499 A1

**In der Beschreibung aufgeführte Nicht-Patentliteratur**

- **W. König ; F. Klocke.** Fertigungsverfahren 3, Elektrochemisches Abtragen,. Springer, 1997, 91-121

- **E. Lassner ; W.D. Schubert.** Tungsten, Part Electrolytes. Kluwer Academic, 1998